# EUROPEAN PATENT SPECIFICATION

(11) **EP 0 440 326 B1**
(45) Date of publication and mention of the grant of the patent: **14.12.1994**
(21) Application number: 91300010.5
(22) Date of filing: 02.01.1991
(51) Int. Cl.: C23C 14/06, C23C 14/32

(54) **Method of depositing diamond-like film onto a substrate having a low melting temperature**
Verfahren zum Aufdampfen eines diamantähnlichen Films auf ein niedrig schmelzendes Substrat
Méthode pour déposer un film de i-carbone sur un substrat ayant un bas point de fusion

(30) Priority: 29.01.1990 US 417849
(43) Date of publication of application: 07.08.1991
(73) Proprietor: BAUSCH & LOMB INCORPORATED, Rochester New York 14601-0054 (US)
(72) Inventor: Cumbo, Michael J., Rochester, New York 14625 (US)
(74) Representative: Allam, Peter Clerk

(56) References cited:
- EP-A- 0 267 679
- US-A- 3 756 193
- US-A- 4 725 345
- THIN SOLID FILMS, vol. 148, no. 3, 27th April 1987, pages 323-332; A. CELERIER et al.: "Metallization of polytetrafluoroethylene substrates by ion plating"

## Description

The invention is related to processes for vacuum deposition of thin diamond-like carbon films on a plastics substrate having a relatively low melting temperature such as plastics lenses.

Optical lenses used in eye wear for protecting the eye from bright light fall into one of two categories. The first category includes plastics lenses such as those comprising polycarbonate or CR39 (allyl di-glycol carbonate). The advantages of this type of lens are that it is relatively light weight and does not tend to shatter under hard impact. A secondary advantage is that a polarizing material such as polyvinyl alcohol may be readily integrated on the plastics material to enable the lens to prevent annoying reflected glare from reaching the eye. A severe disadvantage is that the plastics material is relatively soft and therefore is easily scratched, disfigured or otherwise rendered useless as an optical lens. Moreover, such plastics materials are not practically susceptible of being hardened by known processes, such as deposition of diamond-like carbon films. This is because such processes are typically carried out at high temperatures, raising the temperature of the substrate above its melting point.

A second category includes glass lenses, which enjoy the distinct advantage of being very hard and therefore virtually impervious to scratching under normal use. While the lenses made from such materials are therefore more durable and longer-lasting, they suffer from several significant disadvantages. First, glass lenses are very heavy, thus making eye-wear in which they are used less comfortable. Secondly, glass lenses tend to shatter in response to a sufficiently hard impact and they cost more than plastics lenses. Another disadvantage is that there is no practical method for providing polarizing material on a glass lens.

Accordingly there is a great need in the art for a lens which enjoys the advantages of a plastic lens as well as the advantages of a glass lens without suffering from the disadvantages of either. Such a need could be met if a practical way could be found to deposit a diamond-like carbon film on a plastics lens or on a lens having a plastics coating or surface.

Various processes for depositing diamond-like carbon on a substrate are known. However, few of them are disclosed as being useful with substrates such as plastics which melt at temperatures between 80°C and 150° C. It is believed that in many cases such processes raise the substrate temperature well beyond 150° C and therefore cannot be used to deposit diamond-like carbon on a plastics substrate. However, as will be described later in this specification, the present invention employs relatively low temperatures of less than about 150°C, preferably less than 100°C and most preferably less than about 80°C, thereby allowing deposition of diamond-like carbon on substrates having lower melting temperatures.

U.S. Patent No. 3,961,103 to Aisenberg discloses a process for depositing a diamond-like carbon film on a substrate with a glow discharge carbon ion source and an RF electric field to attractively bias the surface of the substrate while avoiding the build-up of a repulsive charge around the substrate in the presence of hydrogen gas. Aisenberg further discloses that the glow discharge carbon ion source and the substrate are held in separate evacuated chambers, the carbon ions reaching the substrate through a special constrictor electrode connecting the two chambers, the constrictor electrode having a particular arrangement with an extractor anode inside the chamber housing the substrate. This process suffers from the disadvantage of requiring two separate chambers with special electrodes to attract the carbon ions from one chamber to the other. A similar process is disclosed in Aisenberg et al. "Ion-Beam Deposition of Thin Films of Diamondlike Carbon," Journal of Applied Physics, Vol. 42, No. 7, pp. 2953-2958 (June 1971).

U. S. Patent No. Re. 32,464 to Aine, discloses a process for depositing on a heated substrate a carbon film of a different type, namely graphite carbon from a carbon ion source. The carbon ions are generated by RF induced plasma sputtering of a carbon target electrode with argon ions from a glow discharge.

German Offenlegungsschrift 2,736,514 discloses a process for depositing a carbon film on a glass substrate using a gaseous hydrocarbon source to produce carbon ions. An RF field on the substrate attracts the carbon ions to the substrate.

Banks et al., "Ion Beam Sputter-Deposited Diamondlike Films," Journal of Vacuum Science Technology, Vol. 21, pp. 807-814 (Sept./Oct. 1982) discloses a process for depositing diamond-like carbon films on a substrate by sputtering carbon from a graphite target onto the substrate while bombarding the substrate itself with argon ions. The process is directed to substrates such as silica, copper and tantalum which can endure relatively high temperatures.

U.S. Patent No. 4,490,229 to Mertich et al. discloses a process for depositing diamond-like carbon films onto a substrate by an ion beam containing argon ions and a hydrocarbon gas such as methane while a second argon ion beam bombards the substrate which removes the lesser bound carbon atoms from the substrate.

U.S. Patent No. 4,725,345 to Sakamoto et al. discloses a process for depositing a diamond-like carbon film onto an acoustic diaphragm substrate by vaporizing carbon from a solid carbon source using an electron beam. This process suffers from the disadvantage that a D.C. (constant) field is applied to the substrate to attract the vaporized carbon, so that a repulsive surface charge accumulates on the non-conductive substrates. Therefore, the process is not suitable for use with insulating substrates such as plastics. More importantly, this process also suffers from the disadvantage that the electron beam vaporization of the solid carbon target requires a lower ambient pressure while the carbon deposition on the substrate requires a higher ambient pressure. The electron beam vaporisation step must be carried out at a low ambient pressure of about 1.33 x 10⁻² Pa (10⁻⁴ torr) because at higher pressures the electron beam source is unstable due to discharge or breakdown ionization of the surrounding gas. This in turn causes the trajectory of the electron beam to be unstable. The carbon vaporisation step must be carried out at a higher pressure of around 1.33 Pa or 1.33 x 10⁻¹ Pa (10⁻² or 10⁻³ torr) because at lower pressures there are not enough collisions between atoms and molecules in the gas atmosphere surrounding the substrate for the applied electric field to excite a plasma around the substrate. Thus, the vaporisation and deposition steps appear to be incompatible for carrying out in the same vacuum chamber.

EP-A-0267679 discloses a process for coating a substrate, which may be a plastics lens with a low melting temperature, with an abrasion-resistant carbon coating. The carbon coating is graded in composition, being essentially amorphous at the substrate-coating interface and, in one embodiment, diamond-like at the outer surface of the coating, and is formed by contacting the substrate to be coated with a deposition gas comprising a hydrocarbon gas and inert gas at a pressure of less than 0.1 Pa (1 x 10⁻⁶ atmospheres), forming a microwave plasma in contact with the substrate at relatively low microwave power to decompose the hydrocarbon gas and deposit a disordered carbon coating on the substrate, and thereafter increasing both the microwave power and the gas pressure to obtain a more ordered e.g. diamond-like carbon deposit. However, whilst this prior process does permit the use of plastics substrates, it nonetheless does not provide a coating which is diamond-like throughout its thickness.

In summary, none of the foregoing processes appear to be useful for depositing diamond-like carbon films on substrates having low melting temperatures such as plastics lenses. Some of the processes involve ion beam bombardment or glow discharging which may increase the substrate temperature above the melting point of the substrate. Another process involving electron beam vaporization of a solid carbon source is problematic because its vaporization and deposition steps should be carried out at different pressures and are therefore incompatible for use in the same vacuum chamber.

In accordance with the present invention there is provided a method of depositing a diamond-like carbon film onto the surface of a plastics substrate without melting the substrate and without accumulating a large repulsive charge around the substrate, which comprises:
directing an electron beam at a solid carbon source in a chamber so as to vaporize carbon from the solid carbon source while maintaining a first pressure in the vicinity of the electron beam; and
holding the substrate in a fixture in the chamber while applying a high frequency RF voltage to said fixture and while maintaining in the vicinity of the substrate a second pressure greater than the first pressure.

In the invention, a diamond-like carbon film is deposited on the surface of a plastics substrate such as a plastics lens in order to render the substrate surface hard and scratch-resistant while maintaining the substrate's temperature below its melting point. The invention can employ relatively low temperatures of less than about 150°C, preferably less than 100°C and most preferably less than about 80°C, thereby allowing deposition of diamond-like carbon on substrates having low melting temperatures. The carbon is first vaporized by directing an electron beam at a solid carbon source in a vacuum chamber containing the substrate. An applied electric field around the substrate ionizes the hydrogen to facilitate diamond-like carbon deposition on the substrate and selective etching from the substrate of non-diamond-like carbon by the hydrogen gas. The advantage of using electron beam vaporization of solid carbon is that the diamond-like carbon deposition occurs at ambient temperatures which do not cause the substrate temperature to be raised to its melting point. One problem in using electron beam vaporization of solid carbon for this purpose is that both the substrate and the carbon film are electrically non-conductive materials, so that repulsive charge accumulated during deposition of carbon on the substrate surface will build up until it prevents further ion bombardment of the substrate. In order to solve this problem, the applied electric field is generated by capacitively coupling a radio frequency (RF) voltage to a rotating fixture holding the substrate. The RF voltage creates an RF field which ionizes the atmosphere around the substrate. The advantage of the RF field is that, unlike a constant field, the RF field avoids the accumulation of a repulsive charge around the substrate which would inhibit the deposition of diamond-like carbon.

The invention employs a differentially evacuated chamber which maintains the atmospheric pressure around the solid carbon source on one side of the chamber at a suitably low pressure to permit stable operation of the electron beam source and stable trajectory of the electron beam while maintaining the substrate on the opposite side of the chamber at a higher pressure suitable for maintaining a plasma of ionized gas around the substrate. Suitably, the two sides of the chamber are separated by a baffle having a 3.8 cm (1.5 inch) opening through which the vaporized carbon flows from the source to the substrate. In the preferred embodiment, the differentially evacuated chamber has a bypass manifold connecting the two sides of the chamber. A control system responding to a pressure sensor inside the chamber governs the position of a butterfly valve in the bypass manifold to regulate the differential pressure across the baffle. In order to assure that the substrate temperature is maintained below 100°, the rotating fixture holding the substrate is water-cooled. A quartz crystal monitor senses the amount of vaporized carbon reaching the substrate. A controller sensing the output of the quartz crystal monitor regulates the rate at which the electron beam vaporizes the solid carbon source in order to maintain the rate at which carbon is deposited on the substrate at a predetermined level.

The diamond-like carbon film exhibits many of the desirable physical properties of naturally occurring diamond which make the film particularly useful as a protective coating on optical components or eye wear. These properties include excellent mechanical hardness, chemical durability and low optical absorption over a wide spectral range. The combination of plastics substrate and the diamond-like carbon film makes possible light-weight scratch-resistant lenses, thus fulfilling a long-standing need in the art.

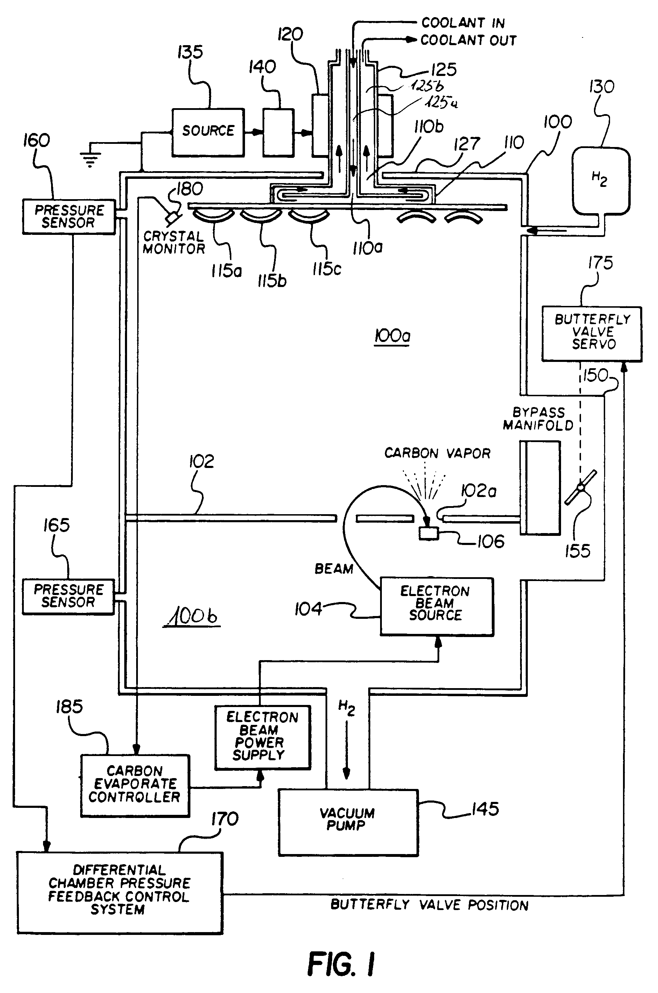

A preferred embodiment of the invention is described in detail below by reference to the accompanying drawing of Fig. 1, which is a diagram of apparatus including a differentially evacuated chamber for carrying out the invention.

Referring now to Fig. 1, a sealed vacuum chamber 100 is divided into two sides 100a and 100b by a baffle 102 having an opening 102a of about 3.8 cm (1.5 inch) in diameter permitting vapor flow between the two sides 100a, 100b of the chamber 100. An electron beam generator 104 directs an electron beam at a solid carbon target 106 in the second side 100b of the chamber 100 near the opening 102. The solid carbon target 106 is preferably graphite. While the carbon target 106 and the electron beam generator 104 are separated in Fig. 1 for the sake of clarity, it should be understood that actually they are in physical contact in accordance with standard practice. A rotating electrically conductive fixture 110 in the first side 100a of the chamber 100 holds substrates 115a, 115b, 115c, etc. on which diamond-like carbon film is to be deposited. The substrates 115 may, for example, be plastics lenses. A rotating drive assembly 120 turns a rotating shaft 125 extending through the wall 127 of the chamber 100 to rotate the fixture 110. A hydrogen gas supply 130 furnishes hydrogen gas to the interior of the chamber 100. In order to ionize the hydrogen gas around the substrates 115, an RF power source 135 applies a high frequency voltage through a capacitive tuning network 140 to the drive shaft 125 which is thereby coupled to the conductive fixture 110. The alternating nature of the field thereby produced in the chamber 100 prevents the build-up of a repulsive surface charge on the substrates 115 during diamond-like carbon formation. At the same time the field maintains a plasma around the substrates 115 and attracts the hydrogen ions and electrons to the substrates during alternate half cycles of the sine wave. Preferably, the frequency of the RF source 135 is around 13.56 MHz while its power density is sufficient to ionize the atmosphere around the substrates 115. This power density as measured at the capacitive tuning network 140 is in excess of 0.1 watts/cm² and preferably lies the range between 0.2 watts/cm² and 1.0 watts/cm². The ionized hydrogen gas enhances the formation of diamond-like carbon (hybrid sp³ carbon) on the substrates 115 by acting as a selective etchant. The hydrogen chemically combines with any non-diamond-like carbon or graphite (hybrid sp² carbon) on a substrate surface to form methane gas which evaporates away. Preferably, the hydrogen gas is mixed with a small amount of argon in the ratio of 50:1.

The carbon deposition on the substrates 115 should be carried out at an ambient pressure of at least around 1.33 Pa or 1.33 x 10⁻¹ Pa (10⁻² or 10⁻³ torr) in order for the applied electric field to maintain a plasma of ionized vapor near the substrate, while the carbon vaporization of the graphite source 106 should be carried out at an ambient pressure of no greater than 1.33 x 10⁻² Pa (about 10⁻⁴ torr) in order to permit stable operation of the electron beam source 104. In order to accomplish this, the chamber 100 is differentially evacuated across the baffle 102. The ambient pressure in the vicinity of the substrates 115 in the first side 100a of the chamber 100 is maintained at the higher pressure (around 1.33 Pa to 1.33 x 10⁻¹ Pa). The ambient pressure in the vicinity of the electron beam path between the electron beam source 104 and the solid carbon target 106 in the second side 100b of the chamber 100 is maintained at or below the lower pressure (around 1.33 x 10⁻² Pa). A vacuum pump 145 evacuates the second chamber side 100b to about 1.33 x 10⁻² Pa (10⁻⁴ torr). The pressure difference across the baffle 102 is controlled through a bypass manifold 150 by a butterfly valve 155. The bypass manifold 150 has a diameter of about 7.6 cms (three inches). A first pressure sensor 160 senses the ambient pressure in the first side 100a of the chamber 100 near the substrates 115 while a second pressure sensor 165 allows the user to inspect the ambient pressure in the second side 100b of the chamber 100. The vacuum pump 145 is selected so as to maintain this pressure at or below 1.33 x 10⁻² Pa (10⁻⁴ torr). A differential chamber pressure feedback control system 170 responds to the output of the first pressure sensor 160 to control the position of the butterfly valve 155 through a butterfly valve servo 175 in order to regulate the ambient pressure near the substrates 115 in the first side 100a of the chamber 100. The resonant frequency of a quartz crystal monitor 180 near the substrate fixture 110 changes as vaporized carbon accumulates on its surface. The rate at which carbon accumulates on the quartz crystal monitor 180 is proportional to the rate at which carbon is deposited on the nearby substrates 115. A controller 185 regulates the rate at which carbon is vaporized from the graphite source 106 by sensing the change in the resonant frequency of the quartz crystal monitor and adjusting the filament current in the electron beam source 104 so as to achieve the requisite carbon deposition rate on the substrates 115. Typically, the controller 185 maintains the carbon deposition rate at a selected point between 3 nm/minute and 30 nm/minute. (30 angstroms/minute and 300 angstroms/minute).

As a safeguard which assures that the temperature of the substrates 115 is maintained at about 75° C, the substrates are cooled by circulating a coolant such as water through the substrate fixture 110. For this purpose, the substrate fixture 110 has a hollow interior divided into an input cavity 110a and an output cavity 110b. Coolant is pumped down a hollow interior passage 125a in the center of the shaft 125 and returns through another hollow interior passage 125b in the shaft 125 concentrically surrounding the passage 125a.

A working example of the diamond-like carbon deposition process of the present invention is as follows:
(1) Load clean substrates 115 onto the substrate fixture 110;
(2) Evacuate the chamber 100 to about 1.33 x 10⁻⁴ Pa (10⁻⁶ torr);
(3) Establish gas flow into chamber from the hydrogen gas supply 130;
(4) Set the pressure in the first chamber side 100a to 4 x 10⁻¹ Pa (3x10⁻³ torr);
(5) Apply power from the RF source at a power density between 0.2 to 1.0 watts/cm²; and
(6) Evaporate carbon from the solid graphite source 106 with the electron beam generator 104 at a deposition rate of between 3 and 30 nm/minute.

In this working example, the pressure sensor 160 was an MKS Baratron 390HA pressure transducer and the feedback control system 170 consisted of an MKS 270B signal conditioner connected to the output of the pressure sensor 160 and an MKS 252A exhaust valve controller connected to the output of the signal conditioner. The butterfly valve 155 was an MKS 253A variable orifice exhaust valve. All such MKS parts were purchased from MKS Instruments, Inc. in Andover, Massachusetts. The controller 185 connected to the quartz crystal monitor 180 was an Inficon IC-6000 Deposition Controller purchased from Inficon Leibold Heraus, Inc. in Syracuse, New York. The electron beam power supply was an Eratron EB8-111 8kW unit (with sweep control) from Innotec Group Inc., Simi Valley, California. The electron beam source was a Temescal STIH-270-2MB electron beam gun from Airco Temescal, Berkeley, California.

## Claims

1. A method of depositing a diamond-like carbon film onto the surface of a plastics substrate without melting the substrate and without accumulating a large repulsive charge around the substrate, which comprises:
directing an electron beam at a solid carbon source in a chamber so as to vaporize carbon from the solid carbon source while maintaining a first pressure in the vicinity of the electron beam; and
holding the substrate in a fixture in the chamber while applying a high frequency RF voltage to said fixture and while maintaining in the vicinity of the substrate a second pressure greater than the first pressure.

2. The method of Claim 1, wherein the first pressure is sufficiently low to stabilize the electron beam and the second pressure is sufficiently high to enable the RF voltage to excite a plasma of ionized gas around the substrate.

3. The method of Claim 1 or Claim 2, further comprising:
monitoring the rate at which carbon is deposited on the substrate; and
controlling the current of the electron beam in response to the monitoring step.

4. The method of any preceding claim, further comprising rotating the substrate.

5. The method of any preceding claim, further comprising cooling the substrate so as to maintain its temperature below its melting temperature.

6. The method of Claim 4 and Claim 5, wherein the substrate is held in a rotating fixture in said chamber and wherein the cooling step comprises transporting a coolant through the fixture so as to remove heat therefrom.

7. The method of any preceding claim, wherein the melting temperature of the substrate is less than 150°C.

8. The method of Claim 7, wherein said melting temperature is less than 100°C.

9. The method of any preceding claim, wherein the first pressure is less than 1.33 x 10⁻² Pa (10⁻⁴ torr) and the second pressure is in the range of 1.33 Pa to 1.33 x 10⁻¹ Pa (10⁻² to 10⁻³ torr).

## Patentansprüche

1. Verfahren zum Abscheiden eines diamantähnlichen Pulverfilmes auf der Oberfläche eines Kunststoffsubstrates ohne Schmelzen des Substrates und ohne Anhäufen einer großen abstoßenden Ladung um das Substrat, das die folgenden Schritte umfaßt:
Richten eines Elektronenstrahles auf eine feste Kohlenstoffquelle in einer Kammer, um Kohlenstoff aus der festen Kohlenstoffquelle zu verdampfen, während ein erster Druck in der Nachbarschaft des Elektronenstrahles aufrechterhalten wird; und
Halten des Substrates in einer Befestigung in der Kammer, während eine Hochfrequenzspannung an die Befestigung gelegt und in der Nachbarschaft des Substrates ein zweiter Druck aufrechterhalten wird, der größer ist als der erste Druck.

2. Verfahren nach Anspruch 1, bei dem der erste Druck ausreichend niedrig ist, um den Elektronenstrahl zu stabilisieren, und der zweite Druck ausreichend hoch ist, damit die Hochfrequenzspannung ein Plasma aus ionisiertem Gas um das Substrat erregen kann.

3. Verfahren nach Anspruch 1 oder 2, das des weiteren umfaßt,
Überwachen des Maßes, mit dem Kohlenstoff auf dem Substrat abgeschieden wird, und
Steuern des Stromes des Elektronenstrahles in Abhängigkeit vom Überwachungsschritt.

4. Verfahren nach einem der vorangehenden Ansprüche, das des weiteren das Drehen des Substrates umfaßt.

5. Verfahren nach einem der vorangehenden Ansprüche, das des weiteren das Kühlen des Substrates umfaßt, um dessen Temperatur unter seiner Schmelztemperatur zu halten.

6. Verfahren nach Anspruch 4 und Anspruch 5, bei dem das Substrat in einer rotierenden Befestigung in der Kammer gehalten wird und der Kühlschritt das Fördern eines Kühlmittels durch die Befestigung umfaßt, um hiervon Wärme zu entfernen.

7. Verfahren nach einem der vorangehenden Ansprüche, bei dem die Schmelztemperatur des Substrates geringer ist als 150°C.

8. Verfahren nach Anspruch 7, bei dem die Schmelztemperatur geringer ist als 100°C.

9. Verfahren nach einem der vorangehenden Ansprüche, bei dem der erste Druck geringer ist als 1,33 x 10⁻² Pa (10⁻⁴ Torr) und der zweite Druck in einem Bereich von 1,33 Pa bis 1,33 x 10⁻¹ Pa (10⁻² bis 10⁻³ Torr) liegt.

## Revendications

1. Procédé de dépôt d'une couche de carbone analogue à du diamant sur la surface d'un substrat de matière plastique sans fusion du substrat et sans accumulation d'une grande charge répulsive autour du substrat, qui comprend :
la direction d'un faisceau d'électrons sur une source de carbone solide dans une chambre afin que le carbone de la source de carbone solide se vaporise avec maintien d'une première pression au voisinage du faisceau d'électrons, et
le maintien du substrat dans un dispositif de montage à l'intérieur de la chambre, avec application d'une tension à hautes fréquences RF au dispositif de montage et maintien d'une seconde pression supérieure à la première au voisinage du substrat.

2. Procédé selon la revendication 1, dans lequel la première pression est suffisamment faible pour stabiliser le faisceau d'électrons, et la seconde pression est suffisamment élevée pour permettre à la tension à hautes fréquences d'exciter un plasma de gaz ionisé autour du substrat.

3. Procédé selon la revendication 1 ou 2, comprenant en outre :
le contrôle de la vitesse à laquelle le carbone se dépose sur le substrat, et
le réglage du courant du faisceau d'électrons en fonction de l'étape de contrôle.

4. Procédé selon l'une quelconque des revendications précédentes, comprenant en outre l'entraînement en rotation du substrat.

5. Procédé selon l'une quelconque des revendications précédentes, comprenant en outre le refroidissement du substrat afin que sa température soit maintenue au-dessous de sa température de fusion.

6. Procédé selon les revendications 4 et 5, dans lequel le substrat est maintenu dans un dispositif rotatif de montage placé dans la chambre, et l'étape de refroidissement comprend le transport d'un fluide de refroidissement dans le dispositif de montage afin qu'il retire la chaleur de ce dispositif.

7. Procédé selon l'une quelconque des revendications précédentes, dans lequel la température de fusion du substrat est inférieure à 150 °C.

8. Procédé selon la revendication 7 , dans lequel la température de fusion est inférieure à 100 °C.

9. Procédé selon l'une quelconque des revendications précédentes, dans lequel la première pression est inférieure à 1,33.10⁻² Pa (10⁻⁴ torr) et la seconde pression est comprise entre 1,33 Pa et 1,33.10⁻¹ Pa (10⁻² et 10⁻³ torr).
